# EUROPEAN PATENT SPECIFICATION

(11) **EP 2 388 605 B1**
(45) Date of publication and mention of the grant of the patent: **17.10.2018**
(21) Application number: 10190157.7
(22) Date of filing: 05.11.2010
(51) Int. Cl.: G01R 31/26

(54) **Testing a light producing element**
Testen eines Lichterzeugungselements
Test d'un élément de production de lumière

(30) Priority: 19.05.2010 IE 20100321
(43) Date of publication of application: 23.11.2011
(73) Proprietor: Feasa Enterprises Limited, National Technology Park Limerick (IE)
(72) Inventor: O'Toole, Eamonn, Castletroy Co Limerick (IE); Crowley, Michael, Annacotty Co Limerick (IE); Davern, Timothy, Annacotty Co Limerick (IE)
(74) Representative: Chettle, John Edward

(56) References cited:
- EP-A1- 1 452 842
- EP-A2- 0 285 493
- WO-A1-01/84901
- US-A1- 2002 003 428

## Description

The present invention relates to an interface module for collecting light from one or more light producing elements on a device and for relaying signals indicative of a characteristic of the light produced by the light producing elements to a central hub unit for analysis thereof. The invention also relates to a test fixture comprising at least one such interface module and a test system and a method for testing light produced by one or more light producing elements on a device.

Printed circuit boards, in general, comprise a large number of light producing elements, for example, light emitting diodes (LEDs), and in many cases a signal printed circuit board may comprise up to, and indeed more than, four hundred LEDs. Usually, each of the light producing elements is tested, firstly, to ensure that it is operational, in other words, operates in the on state and in the off state when it should be in the respective ones of the on and off state, secondly, to ensure that it produces light of the correct colour and, thirdly, to ensure that it produces light to a correct level of intensity.

Test fixtures for testing the operational status of LEDs on printed circuit boards and the colour and intensity of the light they produce are known. Such test fixtures, in general, comprise a jig for receiving a printed circuit board to be tested. A plurality of optical fibres for collecting light from the LEDs extend from the jig at locations corresponding to the locations of the LEDs on the printed circuit board. A clamping arrangement is provided for clamping the printed circuit board onto the jig with the LEDs aligned with the ends of the optical fibres in the jig. The other ends of the optical fibres terminate in releasable optical couplers which are located in a side wall of the test fixture. A central hub unit, in which light signals from the test fixture are analysed, comprises a plurality of corresponding optical fibres which are coupled to the optical fibres of the test fixture via the releasable optical couplers. The light signals, when received in the central hub unit, are then converted to digital signals for analysis to establish operational status, colour and light intensity of the light produced by the corresponding LED. Analysed data from the central hub unit is then outputted to an appropriately programmed computer, such as a personal computer, where the data is further processed and displayed. The data indicative of the operational status, the colour and light intensity of the LEDs may be displayed graphically or in the form of alphanumeric characters.

Such test systems tend to be inefficient and, in many cases, the displayed data relating to the operational status, the colour and light intensity of the light produced by the LEDs may be inaccurate. This largely results from the difficulty of achieving good connections between the optical fibres of the central hub unit and the optical fibres of the text fixtures through the releasable optical couplers. Light transfer through such optical couplers can be relatively inefficient, even where suitable index matching gel is used in the coupler. Indeed, in general, without the use of index matching gel, losses of up to 80% can occur in optical couplers and, even where optical gels are used, the losses in optical couplers are typically of the order of 50% to 60%. Moreover, changing such a prior test system, for example, by replacing one test fixture with another, might require the optical couplers to be released, so that the central hub unit can be connected to optical fibres of a different test fixture. This would require new optical connections to be made. WO 01/84901 A1, US 2002/003428 A1, EP 1 452 842 A1, EP 0 285 493 A2 disclose testing of light emitting devices. An object of the present invention is the provision of an interface module for use in a test fixture in a test system and a method of collecting light from one or more light producing elements and relaying signals indicative of a characteristic of the light produced by the light producing elements to a central hub unit that can potentially reduce the losses associated with the prior art systems discussed above.

According to one aspect of the invention, a test fixture is defined in the claim 1.

For example, the one or more output signals may be indicative of an amount of light collected by the light collectors, such as an indication of intensity of the collected light. The indication of intensity of the collected light may be an indication of a relative intensity, that is, the intensity of the collected light relative to a predetermined reference intensity value.

Alternatively, or additionally, the one or more output signals may be indicative of a colour of the light collected by the light collectors.

Alternatively, or additionally, the one or more output signals may be indicative of an operational status of one or more of the light producing elements. For example, the one or more output signals may be indicative of an on/off status of a light producing element determined from the amount of collected light.

The converters may be configured to generate the electronic signals as analogue signals. Such converters may include analogue-to-digital converters to convert the analogue signals to digital signals. Alternatively, the converters may be configured to generate the electronic signals as digital signals.

The one or more output signals may include, or correspond to, the electronic signals generated by the converter.

Where the one or more output signals are conveyed to a hub unit for analysis, the interface module may include a communication interface configured to communicate with such a hub unit. The communication interface may be a digital interface. Alternatively, or additionally, the output may be an electrical pin connector through which the interface module can be connected, directly or indirectly, to a hub unit.

Alternatively, or additionally, the interface module may include a processing arrangement having one or more processors configured to process the electronic signals and generate the one or more output signals. In other words, the interface module may be configured to perform an analysis of the electronic signals output by the converters and the one or more output signals may include, or correspond to, the result of such analysis.

One or more memory facilities may be provided in the interface module to store multiple software algorithms to be used in the analysis of the electronic signals, for example, to determine different characteristics of the collected light, to employ different analytical techniques and/or to test selected groups of light producing elements on a device by analysing light collected by a selected subset of the light collectors. Where such memory facilities are provided, the processing arrangement can be configured to select and execute one of the stored software algorithms. Such an arrangement allows different tests to be performed without requiring reconfiguration of the hardware of the interface module or of test fixture or test system in which the interface module is used. Moreover, where more than one interface module is provided, different tests on respective subsets of the light producing elements may be performed by the respective interface modules simultaneously.

The interface module may include a multiplexer configured to provide a multiplexed output signal. For example, the multiplexer may combine the electronic signals in a series, so that they are output sequentially in the output signal. Where the converters are configured to produce digital electronic signals, the multiplexer may be a digital multiplexer. Such a digital multiplexer may be in the form of a programmable logic device.

In any of the modules described above, a calibrator may be provided and configured to store calibration values for respective ones of the converters for use in correcting the electronic signals for errors introduced during the conversion.

The light collectors may be optical fibres. A plurality of such optical fibres may extend from a housing of a test fixture, in which the interface module is mounted, and be arranged to direct light to respective ones of the converters. Respective lenses may be provided at the one or more ends of the optical fibres. For example, lenses may be provided at the ends of the optical fibres that are proximal to the converters, configured to focus light onto the respective converter and/or lenses may be provided at the distal ends of the optical fibres to focus light from a light producing element into the optical fibre.
The invention also provides a test fixture including any of the above interface modules. The test fixture may comprise more than one of the interface modules. Where the light collectors include optical fibres, the text fixture may be configured to mount distal ends of the optical fibres at locations corresponding to the positions of light producing elements under test.

The invention also provides a test system as defined in the claim 9.

The test system may also include an output device, arranged to receive the processed signals from the hub unit and to display data conveyed by the processed signals using images and/or alphanumeric characters on a display medium, such as a display screen or print medium.
The invention also provides a method for testing a plurality of light producing elements, as defined in the claim 10.

For example, the one or more output signals may be indicative of an amount of light collected by the light collectors, such as an indication of intensity of the collected light and/or an on/off status of a light producing element determined from the amount of collected light. The indication of intensity of the collected light may be an indication of a relative intensity, that is, the intensity of the collected light relative to a predetermined reference intensity value.

The electronic signals may be generated as analogue signals or as digital signals. The conversion may include converting analogue signals into digital signals.

The one or more output signals may be indicative of a colour of the light collected by the light collectors.

The one or more output signals may include, or correspond to, the electronic signals generated the respective converters.

The one or more output signals may be conveyed to a hub unit for analysis.

Alternatively, or additionally, the generation of the one or more output signals may include processing the electronic signals. For example, the processing may include performing an analysis of the electronic signals and the one or more output signals may include, or correspond to, the result of such analysis. In such a case, the method may include selecting one of a plurality of stored software algorithms to be used in the analysis of the electronic signals, for example, to determine different characteristics of the collected light and/or to employ different analytical techniques.

The generation of the one or more output signals may include multiplexing the electronic signals or, where an analysis has been performed, signals indicating the results of such analysis. For example, the one or more output signals may include the electronic signals or analysis results in series.

The conversion may include correcting the electronic signals for errors introduced during the conversion. Such correction may be based on previously stored calibration values.

Example embodiments of the present invention will now be described with reference to the accompanying drawings, of which:
Figure 1 depicts a test system according to an embodiment of the present invention;
Figure 2 depicts a test fixture according to an embodiment of the invention, for use in the test system of Figure 1;
Figure 3 depicts an interface module according to an embodiment of the invention, for use in the test fixture of Figure 2;
Figure 4 depicts a hub unit of the test system of Figure 1;
Figure 5 is a flowchart of a method of testing a light producing element according to an embodiment of the invention; and
Figure 6 is a flowchart of a method of testing a light producing element according to another embodiment of the invention.

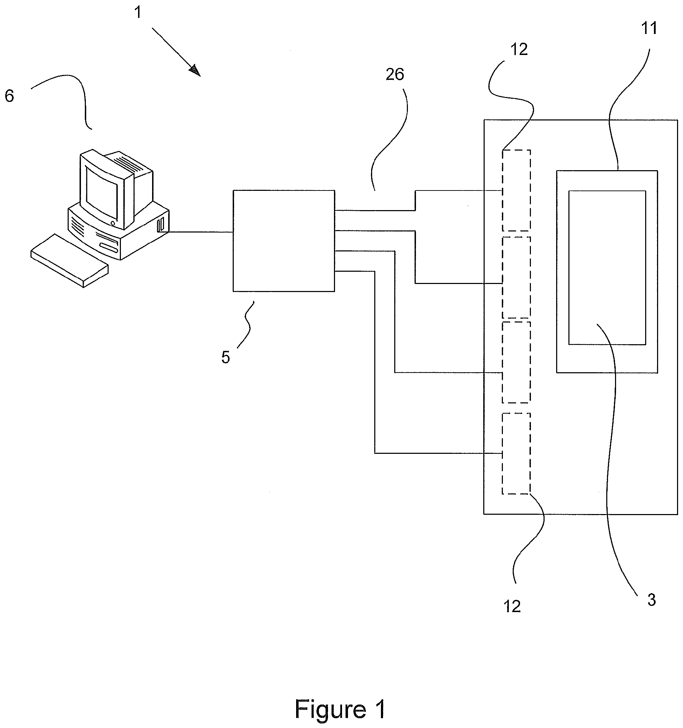

Figure 1 depicts a test system 1 according to an embodiment of the invention, that can be used to test characteristics of light produced by a plurality of light producing elements. In this particular example, the light producing elements are LEDs 2 mounted on a printed circuit board (PCB) 3.

The test system 1 includes a test fixture 4, on which the PCB 3 to be tested is mounted. Light from respective LEDs 2 is collected by the test fixture 4. The collected light, as will be described below, is converted in the test fixture 4 to electronic signals that are indicative of a characteristic of the light produced by the LEDs 2.

In the example embodiment shown in Figure 1, the test system 1 is configured to test the operational status of the LEDs 2, in other words, the on/off status of the LEDs 2, the colour of the light produced by the LEDs 2 and the intensity of the light produced by the LEDs 2. One or more output signals indicative of one or more of those characteristics are relayed to a hub unit 5, which can produce digital data signals suitable for processing by a suitably programmed computer 6, for example, a personal computer arranged to display data representative of the characteristics of the light produced by the LEDs 2 under test. Such data may be displayed either graphically or in alphanumeric characters or both.

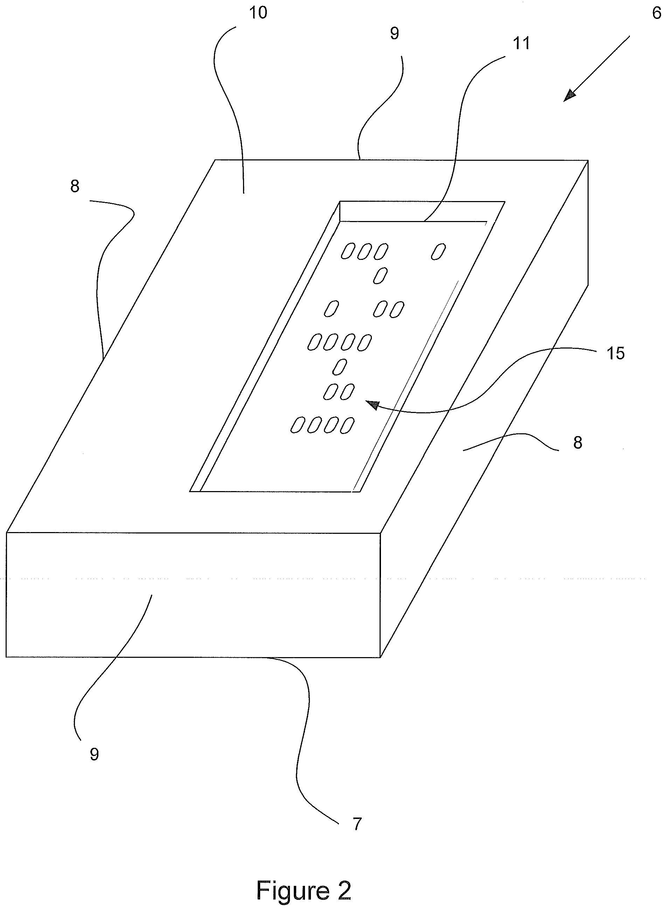

Referring to Figure 2, the test fixture 4 comprises a housing 6 formed by a base 7, a pair of spaced apart side walls 8 extending from the base 7, a pair of spaced apart end walls 9 also extending from the base 7, joining the side walls 8, and a top wall 10. The base 7, side walls 8, end walls 9 and top wall 10 define a hollow interior region. The top wall forms a jig 11 onto which the PCB 3 to be tested can be clamped.

One or more interface modules 12 are located in the interior region of the housing 6 of the test fixture 4 and arranged to collect light from the LEDs 2, to convert the collected light into the electronic signals and to output signals to the hub unit 5.

In this particular embodiment of the invention, four interface modules 12 are provided and each interface module 12 is adapted to collect light from twenty LEDs 2, so that the test fixture 4 can be configured to test up to eighty LEDs. However, in other embodiments, the test fixture 4 may include a different number of interface modules 12, from one upwards. Moreover, each interface module 12 may be configured to test a different number of light producing elements, from one upwards. In addition, respective ones of the interface modules 12 may be arranged to test different numbers of light producing elements.

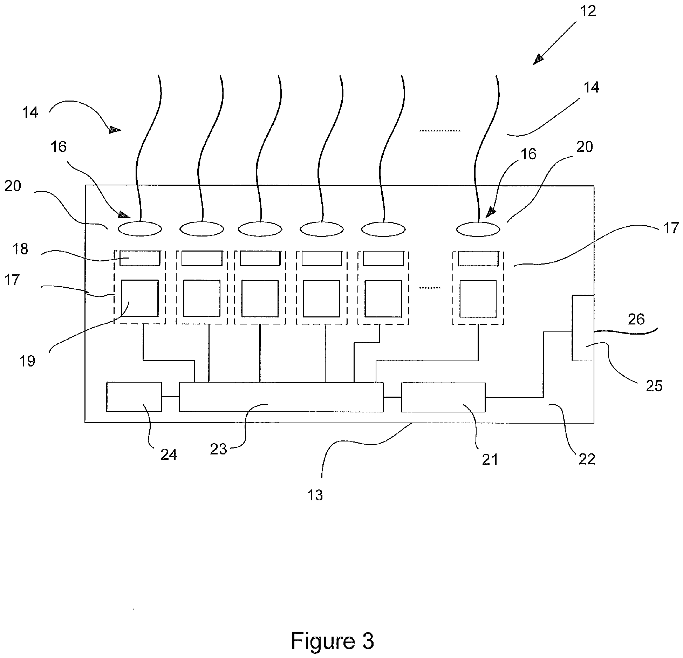

As shown in Figure 3, each interface module 12 comprises a sub-housing 13, within which electronic circuitry is housed. A plurality of light collectors to collect light from the LEDs 2 is provided. In this particular example, the light collectors are optical fibres 14 that extend from the sub-housing 13. The optical fibres 14 terminate at locations on the jig 11 corresponding to locations of respective ones of the LEDs 2, so that when the PCB 3 is mounted on the jig 11, the LEDs 2 are aligned with distal ends 15 of corresponding ones of the optical fibres 14.

Proximal ends 16 of the optical fibres 14 terminate in the sub-housing 13, adjacent to a plurality of light converters 17. The light converters include light sensors 18, configured to convert the light received from respective ones of the optical fibres 14 into electronic analogue signals that are indicative of the intensity and/or colour of the light produced by a corresponding one of the LEDs 2, as received from the optical fibre 14.

In this example, each of the light converters 17 also include an analogue-to-digital converter 19, configured to convert the electronic analogue signal into an electronic digital signal indicative of the intensity and/or colour of the light received from the optical fibre 14.

Lenses 20 may be provided between the proximal ends 16 of the optical fibres 14 and the light sensors 18, arranged to focus light collected in the optical fibres 14 onto the light sensors 18.

In this particular embodiment, a complex programmable logic device 21 is located in the sub-housing 13 of each interface module 12 and arranged to receive the electronic signals, either analogue or digital, from the light converters 17. The programmable logic device 21 is configured as a digital multiplexer to multiplex the electronic signals from the light converters 17 into a single signal for output via a line 22.

A processing arrangement, such as a microcontroller 23, is provided in the sub-housing 13 of each interface module 12 and configured to store calibration data for the respective light sensors 18 and the respective analogue-to-digital converters 19 and to apply appropriate calibration values to the electronic digital signals to correct for errors introduced by the corresponding components of the light converters 17, based on operating software stored in a memory 24. The memory 24 may include more than one data storage facility.

A digital interface 25 is located in the sub-housing 13 of each interface module 12 and operated under the control of the microcontroller 23 to interface with the hub unit 5. An electrical output cable 26 from the digital interface 25 extends from the sub-housing 13 and terminates in a corresponding output port 27, such as a pin connector output port, in one of the walls 8, 9, top 10 or base 7 of the test fixture 4, to allow couple of the interface module 12 to the hub unit 5. Corresponding cables 29 connect the output ports 27 of the test fixture 4 to the hub unit 5, to allow the output signals from the interface module 12 to be transmitted to the hub unit 5.

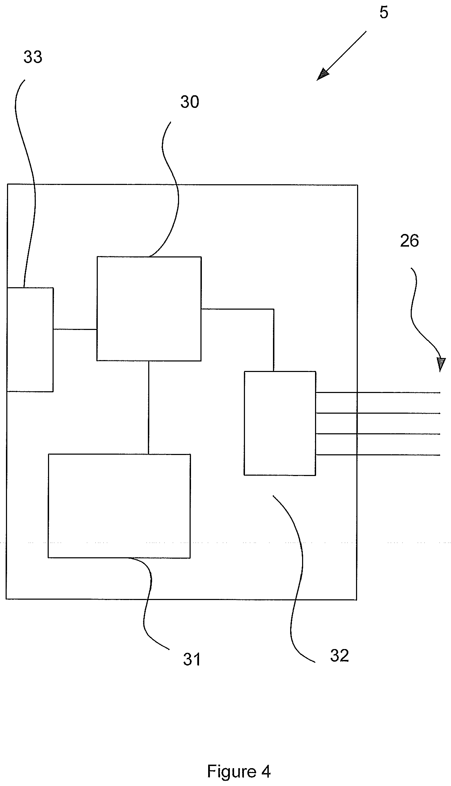

As shown in Figure 4, the hub unit 5 includes a processing arrangement, such as a microcontroller 30, a memory 31 and a demultiplexer 32. The demultiplexer 32 is operated under the control of the microcontroller 30 to apply the output signals from the interface module 12 to the microcontroller 30 selectively and sequentially. The microcontroller 30 is programmed to compute the intensity and/or colour of respective ones of the LEDs 2 from the output signals and to compare the computed data with reference data stored in the memory 31. The computed intensity may be a relative intensity, based on the difference between the intensity of the light detected by a light sensor 18 and a reference intensity level.

Additionally, or alternatively, the microcontroller 30 may be configured to check the operational status of the LEDs 2 using the output signals received from the test fixture 4.

The results of the comparison and/or the operational status check are then outputted by the microcontroller 30 of the hub unit 5 to the computer 6 for further analysis and/or display, via a communication port 33. In this particular example, the communication port 33 is a high-speed interface port.

The test system 1 of Figure 1 can provide a number of advantages over prior test systems. As discussed above, in prior test systems, releasable optical couplers are used to connect optical fibres extending from a hub unit to optical fibres from a test fixture and that such couplings tend to be inefficient. By way of contrast, in the test system of Figure 1, the light collected by the optical fibres 14 is converted into an electronic signal within the test fixture 4. The hub unit 5 can then be coupled to the test fixture 4 by an electrical connection. Such an electrical connection can be provided, broken and reconfigured more easily than an optical coupling.

In addition, the electronic output signal produced by the interface modules 12 can be transmitted from the test fixture 4 to the hub unit 5 with little or no loss, when compared with the transmission of optical signals in prior test systems. Consequently, the efficiency and accuracy with which the characteristics and/or operational status of a light producing element can be established can be improved over prior test systems.

Moreover, the test fixture 4 can be used to perform tests on a number of different light producing elements, for example, testing LEDs 2 on a plurality of PCBs 3 in sequence, without requiring breaking and reconfiguration of the coupling between the optical fibres 14 and the light sensors 18 of the interface module 12.

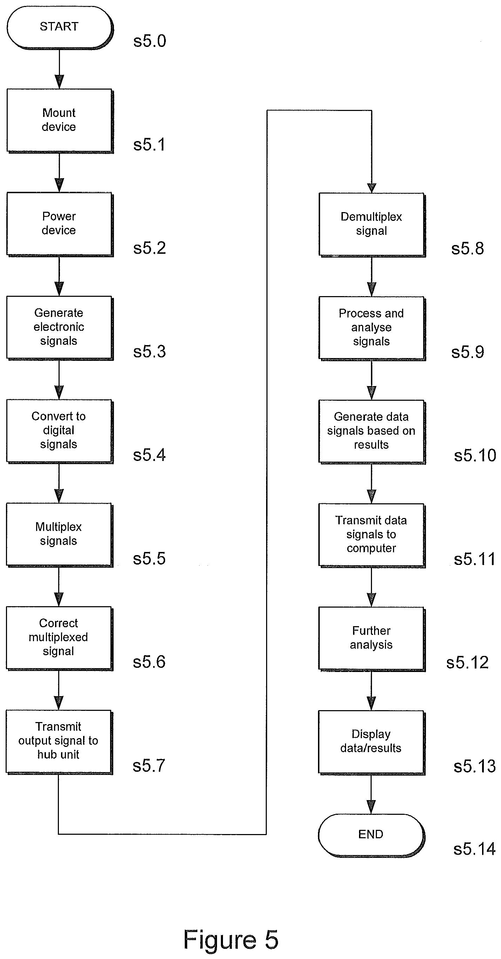

Figure 5 is a flowchart of a method for testing a light producing element using the test system of Figure 1, showing steps performed by the test fixture 4, hub unit 5 and computer 6.

Starting at step s5.0, a PCB 3 to be tested is mounted on the jig 11 (step s5.1), so that the distal ends 15 of the optical fibres 14 receive light from respective ones of the LEDs 2. The PCB 3 is then powered up (step s5.2).

Any light collected by the optical fibres 14 is relayed to corresponding light sensors 18 of light converters 17 in one or more interface modules 12 of the test fixture 4. Electronic analogue signals corresponding to a characteristic of the collected light, if any, are generated (step s5.3) and converted into electronic digital signals by the analogue-to-digital converters 19 (step s5.4).

The programmable logic device 21 multiplexes the electronic digital signals (step s5.5) to produce an output signal and the microcontroller 23 corrects the electronic digital signals for calibration errors (step s5.6). The resulting output signal is transmitted to the hub unit 5 via the digital interface 25 (step s5.7).

The demultiplexer 32 of the hub unit 5 demultiplexes the signal received from the test fixture 4 (step s5.8). The microcontroller 30 of the hub unit 5 then processes the signals and compares them with the reference data stored in the memory 31 (step s5.9). One or more data signals based on the results of the comparison are then generated (step s5.10) by the microcontroller 30 and sent to the computer 6 for further analysis and/or display (steps s5.11, s5.12), completing the test procedure (step s5.13).

In the test system described above, the interface module 12 is configured to generate an electronic output signal that is relayed to a hub unit 5 for processing and analysis. However, in a method according to another embodiment of the invention, such processing and/or analysis may be performed within the interface module 12 or the test fixture 4, as will now be described.

In addition to operating software for the microcontroller 23, a plurality of software algorithms for processing the electronic signals from the light converters 17 may be stored in the memory 24. The software algorithms provide different schemes for processing and analysing the electronic signals. For example, a user might wish to perform a test on a limited subset of the LEDs 2 on the PCB 3, for example, by performing a particular test on LEDs 2 of a particular colour or in one or more particular locations on the PCB 3. In such a case, the microcontroller 23 would be configured to select, retrieve and perform one of the software algorithms to process and/or analyse the corrected electronic data signals to determine one or more characteristics of the collected light and/or LEDs 2 for that subset.

Therefore, the output signal produced by the interface module 12 may convey the result of the analysis. For example, the output signal may indicate one or more of the colour of the collected light, the intensity, or relative intensity, of the collected light and the operational status of the LEDs 2. The output signal may convey a number, in the case of a colour or intensity measure, or a value acting as a flag to indicate a status of "ON" or "OFF" or, in other tests, "PASS" or "FAIL".

The output signal may be transmitted to the hub unit 5 or, in some embodiments, directly to the computer 6.

In this manner, the amount of data transmitted to the hub unit 5 and/or computer 6 can be reduced, particularly where the data is a simple indication of status, such as "ON" or "OFF". Also, as the processing and analysis of the electronic signals can be spread between the interface modules 12 and hub unit 5, this can potentially improve the speed with which a testing procedure can be performed. In addition, this embodiment permits a range of different tests to be performed, without requiring reconfiguration of the hardware of the test system 1. Instead, different tests may be performed by changing the software algorithm used by the microcontroller 23.

In addition, in a test fixture 4 having more than one interface module 12, different tests can be performed on respective subsets of the LEDs 2 simultaneously, by causing the interface modules 12 to select and perform different software algorithms.

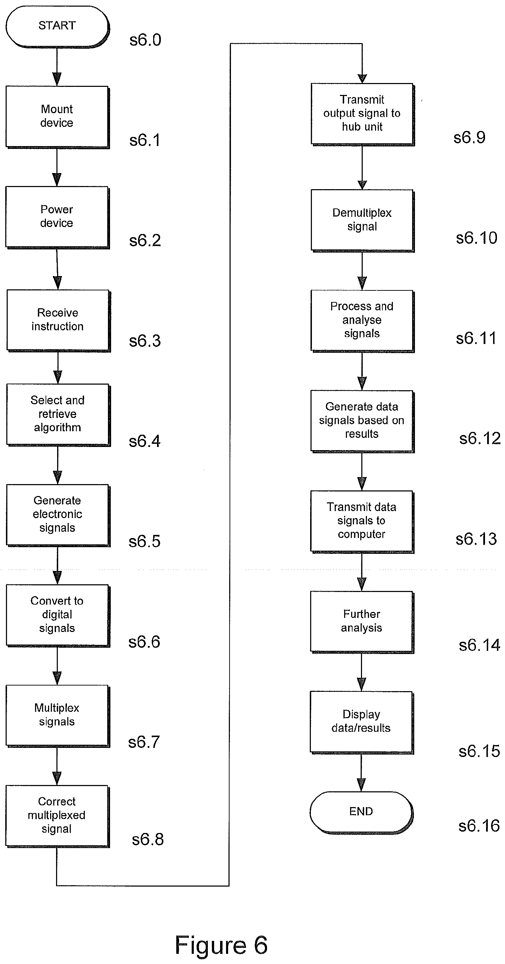

Figure 6 is a flowchart of a method for testing a light producing element using the test system of Figure 1, when such analysis is performed within the test fixture 4.

Starting at step s6.0, a PCB 3 to be tested is mounted on the jig 11 (step s6.1), as described above in relation to Figure 5 (step s5.1). The PCB 3 is then powered up (step s6.2).

The microcontroller 23 receives, from the computer 6, an instruction indicating the type of test to be performed on the LEDs 2 (step s6.3). Such an instruction may be received via the communication port 33 or, where provided, another port, not shown, in the hub unit 5. The microcontroller 23 identifies and selects an appropriate software algorithm and reference data, if any, required to perform that test and retrieves it from the memory 24 (step s6.4).

Electronic analogue signals corresponding to a characteristic of any light collected by the optical fibres 14 are generated (step s6.5) and converted into electronic digital signals by the analogue-to-digital converters 19 (step s6.6). The electronic digital signals are corrected for calibration errors (step s6.7) by the microcontroller 23, based on the reference data stored in the memory 24.

The microcontroller 23 in each of the one or more interface modules 12 corrects the electronic digital signals for calibration errors (step s6.8) and, under the control of the microcontroller 23, analyses the electronic signals according to the retrieved software algorithm (step s6.9). An electronic signal indicative of the results of the analysis is then generated (step s6.10) and multiplexed by the programmable logic device 20 (step s6.11) to produce an output signal (step s6.12).

The output signal is then transmitted to the hub unit 5 or, in certain embodiments, directly to the computer 6, via the digital interface 25 (step s6.13). If required further analysis may be performed by the computer (step s6.14) before results and/or data from the test are displayed or otherwise presented (step s6.15). The test procedure then ends (step s6.16).

The above embodiments describe two methods of operating an interface module 12 within a test fixture 4. In some embodiments, an interface module 12 may be configured to operate using either type of method, that is, in a method where at least some analysis of the electronic signals from the light converters 17 is performed within the test fixture 4, as shown in Figure 6, and a method where such analysis is performed by one or more of a hub unit 5, computer 6 or similar device, for example, as shown in Figure 5.

While, in the above examples, the interface module 12 is configured to test up to 20 light producing elements, interface modules in other embodiments of the invention may be configured with a different number of light collectors, such as optical fibres 14 and light converters 17.

In addition, while the test fixture 4 shown in Figure 2 includes four interface modules 12, in other embodiments of the invention, the test fixture may include another number of interface module 12, from one upwards.

While the optical fibres 14 of each interface module 12 have been described as terminating in the jig 11 of the PCB 3 at locations for directly receiving light from the LEDs 2, in other embodiments, lenses may be provided in the jig 11 at locations corresponding to the positions of the LEDs 2 in the PCB 3. In such a case, the optical fibres would terminate adjacent to the lenses and the lenses would focus light from the LEDs 2 into the optical fibres 14 through the distal ends 15 thereof.

It will also be appreciated that, while the test system 1, test fixture 4 and the interface module 12 have been described for collecting light from LEDs 2 on a PCB 3, the interface module 12, test fixture 4 and test system 1 may be configured to collect light from other types of light producing elements, located on PCBs 3 or on other types of device.

## Claims

1. A test fixture (4) comprising an external housing (6) and an interface module located in the housing, wherein the interface module (12) comprises:
a plurality of light collectors (14);
a plurality of converters (17) arranged to generate an electronic signal based on light collected by respective ones of the light collectors; and
an output (25) arranged to output one or more electronic output signals indicative of a characteristic of the collected light, based on the electronic signal, to a hub unit external to the housing which is configured to receive electronic output signals from a plurality of separate interface modules and to analyse the output signals to determine characteristics of light collected by each interface module, wherein the electronic output signals from the interface module are output to the hub unit via an output port (27) of the test fixture, the output port being electrically connectable to the hub unit for conveying the output signal to the hub unit,
and wherein the external housing (6) comprises a jig (11) arranged to receive a device to be tested.

2. A test fixture according to claim 1, wherein the interface module is configured to generate the one or more output signals to be indicative of an amount of light collected by the light collectors (14).

3. A test fixture according to claim 2, wherein the one or more output signals are indicative of one or more of an intensity of the collected light and an on/off status of a light producing element (2) determined from the amount of collected light.

4. A test fixture according to claim 1, 2 or 3, wherein the one or more output signals are indicative of a colour of the collected light.

5. A test fixture according to any of the preceding claims, wherein the converters (17) are configured to generate the electronic signals as digital signals.

6. A test fixture according to any of the preceding claims, wherein the interface module includes:
a processing arrangement (23) configured to perform an analysis of the electronic signals and generate the one or more output signals based on the result of said analysis.

7. A test fixture according to claim 6, wherein the interface module comprises:
a memory (24) configured to store multiple software algorithms to be used in the analysis of the electronic signals;
wherein the processing arrangement (23) is configured to receive an indication specifying an analysis to be performed, select one of the stored software algorithms corresponding to the specified test and perform said analysis based on said selected algorithm.

8. A test fixture according to claim 7, wherein:
at least one of the multiple software algorithms corresponds to an analysis of light collected by a selected subset of the light collectors (14).

9. A test system (1) comprising:
a test fixture (4) according to any of claims 1 to 8; and
the hub unit (5) external to the housing configured to receive and process the one or more electronic output signals from the test fixture (4), wherein the test fixture is electrically connected to the hub unit to convey the output signals to the hub unit for analysis.

10. A method of testing a plurality of light producing elements, comprising, within a housing (6) of a test fixture (4) comprising at least one interface module and a jig (11) arranged to receive a device to be tested:
collecting light from the light producing elements using a plurality of respective light collectors;
generating electronic signals based on the light collected by respective ones of said light collectors;
generating one or more electronic output signals indicative of a characteristic of the collected light, based on the electronic signals; and
conveying said electronic output signals to a hub unit external to the housing which is configured to receive electronic output signals from a plurality of separate interface modules and to analyse the output signals to determine characteristics of light collected by each interface module, wherein the electronic output signals from the interface module are output to the hub unit via an output port (27) of the test fixture, the output port being connectable to the hub (5).

11. A method according to claim 10, wherein the one or more output signals may be indicative of one or more of an intensity of the collected light, an on/off status of a light producing element determined from the amount of collected light and the colour of the collected light.

12. A method according to claim 10 or 11, wherein:
the generation of the one or more output signals includes performing an analysis of the electronic signals; and
the one or more output signals may include, or correspond to, the result of such analysis.

13. A method according to claim 12, comprising, at the test fixture (4):
receiving an indication of an analysis to be performed;
selecting one of a plurality of stored software algorithms to be used in the analysis of the electronic signals;
performing said analysis based on the selected software algorithm.

14. A method according to claim 13, wherein:
at least one of the plurality of stored software algorithms corresponds to an analysis of light collected by a subset of the light collectors (14).

## Patentansprüche

1. Prüfvorrichtung (4), die ein externes Gehäuse (6) und ein Schnittstellenmodul, das sich im Gehäuse befindet, beinhaltet, wobei das Schnittstellenmodul (12) Folgendes beinhaltet:
eine Vielzahl von Lichtsammlern (14);
eine Vielzahl von Wandlern (17), die angeordnet sind, um ein elektronisches Signal basierend auf dem durch jeweilige der Lichtsammler gesammelten Licht zu erzeugen; und
einen Ausgang (25), der angeordnet ist, um ein oder mehrere elektronische Ausgangssignale, die für eine Charakteristik des gesammelten Lichts indikativ sind, basierend auf dem elektronischen Signal, an eine Hub-Einheit auszugeben, die extern zum Gehäuse liegt, die konfiguriert ist, elektronische Ausgangssignale von einer Vielzahl von getrennten Schnittstellenmodulen zu empfangen und die Ausgangssignale zu analysieren, um Charakteristiken des durch jedes Schnittstellenmodul gesammelten Lichts zu bestimmen, wobei die elektronischen Ausgangssignale über einen Ausgangsanschluss (27) der Prüfvorrichtung vom Schnittstellenmodul an die Hub-Einheit ausgegeben werden, wobei der Ausgangsanschluss zum Leiten des Ausgangssignals an die Hub-Einheit mit der Hub-Einheit elektrisch verbindbar ist,
und wobei das externe Gehäuse (6) eine Haltevorrichtung (11) beinhaltet, die angeordnet ist, um eine zu prüfende Vorrichtung aufzunehmen.

2. Prüfvorrichtung gemäß Anspruch 1, wobei das Schnittstellenmodul konfiguriert ist, ein oder mehrere Ausgangssignale zu erzeugen, um für eine Menge des durch die Lichtsammler (14) gesammelten Lichts indikativ zu sein.

3. Prüfvorrichtung gemäß Anspruch 2, wobei das eine oder die mehreren Ausgangssignale für eines oder mehr von einer Intensität des gesammelten Lichts und eines Ein-/Aus-Status eines lichtproduzierenden Elements (2), bestimmt von der Menge des gesammelten Lichts, indikativ sind.

4. Prüfvorrichtung gemäß Anspruch 1, 2 oder 3, wobei das eine oder die mehreren Ausgangssignale für eine Farbe des gesammelten Lichts indikativ sind.

5. Prüfvorrichtung gemäß einem der vorhergehenden Ansprüche, wobei die Wandler (17) konfiguriert sind, die elektronischen Signale als digitale Signale zu erzeugen.

6. Prüfvorrichtung gemäß einem der vorhergehenden Ansprüche, wobei das Schnittstellenmodul Folgendes umfasst:
eine Verarbeitungsanordnung (23), die konfiguriert ist, eine Analyse der elektronischen Signale durchzuführen und den einen oder die mehreren Ausgangssignale basierend auf dem Ergebnis der Analyse zu erzeugen.

7. Prüfvorrichtung gemäß Anspruch 6, wobei das Schnittstellenmodul Folgendes beinhaltet:
einen Speicher (24), der konfiguriert ist, mehrere Softwarealgorithmen zu speichern, die bei der Analyse der elektronischen Signale zu verwenden sind;
wobei die Verarbeitungsanordnung (23) konfiguriert ist, eine Indikation zu empfangen, die eine durchzuführende Analyse spezifiziert, einen der gespeicherten Softwarealgorithmen entsprechend der spezifizierten Prüfung auszuwählen und die Analyse basierend auf dem ausgewählten Algorithmus durchzuführen.

8. Prüfvorrichtung gemäß Anspruch 7, wobei:
mindestens einer der mehreren Softwarealgorithmen einer Analyse von durch einen ausgewählten Teilsatz der Lichtsammler (14) gesammeltem Licht entspricht.

9. Prüfsystem (1), das Folgendes beinhaltet:
eine Prüfvorrichtung gemäß einem der Ansprüche 1 bis 8; und
die Hub-Einheit (5), die extern zum Gehäuse liegt, konfiguriert ist, das eine oder die mehreren elektronischen Ausgangssignale von der Prüfvorrichtung (4) zu empfangen und zu verarbeiten, wobei die Prüfvorrichtung mit der Hub-Einheit elektrisch verbunden ist, um die Ausgangssignale zur Analyse an die Hub-Einheit zu leiten.

10. Verfahren zum Prüfen einer Vielzahl von lichtproduzierenden Elementen, das, innerhalb eines Gehäuses (6) einer Prüfvorrichtung (4), die mindestens ein Schnittstellenmodul und eine Haltevorrichtung (11), die angeordnet ist, um eine zu prüfende Vorrichtung aufzunehmen, beinhaltet, Folgendes beinhaltet:
Sammeln von Licht von den lichtproduzierenden Elementen unter Verwendung einer Vielzahl von jeweiligen Lichtsammlern;
Erzeugen von elektronischen Signalen basierend auf dem durch jeweilige der Lichtsammler gesammelten Licht;
Erzeugen von einem oder mehreren elektronischen Ausgangssignalen, die für eine Charakteristik des gesammelten Lichts indikativ sind, basierend auf dem elektronischen Signalen; und
Leiten der elektronischen Ausgangssignale an eine Hub-Einheit, die extern zum Gehäuse liegt, die konfiguriert ist, elektronische Ausgangssignale von einer Vielzahl von getrennten Schnittstellenmodulen zu empfangen und die Ausgangssignale zu analysieren, um Charakteristiken des durch jedes Schnittstellenmodul gesammelten Lichts zu bestimmen, wobei die elektronischen Ausgangssignale über einen Ausgangsanschluss (27) der Prüfvorrichtung vom Schnittstellenmodul an die Hub-Einheit ausgegeben werden, wobei der Ausgangsanschluss mit dem Hub (5) verbindbar ist.

11. Verfahren gemäß Anspruch 10, wobei das eine oder die mehreren Ausgangssignale für eines oder mehr von einer Intensität des gesammelten Lichts, eines Ein-/Aus-Status eines lichtproduzierenden Elements, bestimmt von der Menge des gesammelten Lichts, und die Farbe des gesammelten Lichts indikativ sein können.

12. Verfahren gemäß Anspruch 10 oder 11, wobei:
die Erzeugung des einen oder der mehreren Ausgangssignale das Durchführen einer Analyse der elektronischen Signale umfasst; und
das eine oder die mehreren Ausgangssignale das Ergebnis einer solchen Analyse umfassen oder diesem entsprechen können.

13. Verfahren gemäß Anspruch 12, das, an der Prüfvorrichtung (4), Folgendes beinhaltet:
Empfangen einer Indikation für eine durchzuführende Analyse;
Auswählen von einem einer Vielzahl von gespeicherten Softwarealgorithmen, der bei der Analyse der elektronischen Signale zu verwenden ist;
Durchführen der Analyse basierend auf dem ausgewählten Softwarealgorithmus.

14. Verfahren gemäß Anspruch 13, wobei:
mindestens einer der Vielzahl von gespeicherten Softwarealgorithmen einer Analyse von durch einen Teilsatz der Lichtsammler (14) gesammeltem Licht entspricht.

## Revendications

1. Équipement de test (4) comprenant un boîtier extérieur (6) et un module d'interface situé dans le boîtier, dans lequel le module d'interface (12) comprend :
une pluralité de collecteurs de lumière (14) ;
une pluralité de convertisseurs (17) adaptés pour générer un signal électronique sur la base de la lumière collectée par des collecteurs respectifs parmi les collecteurs de lumière ; et
une sortie (25) adaptée pour délivrer un ou plusieurs signaux de sortie électroniques indiquant une caractéristique de la lumière collectée, sur la base du signal électronique, à un ensemble concentrateur extérieur au boîtier qui est configuré pour recevoir des signaux de sortie électroniques d'une pluralité de modules d'interface séparés et pour analyser les signaux de sortie afin de déterminer des caractéristiques de la lumière collectée par chaque module d'interface, dans lequel les signaux de sortie électroniques du module d'interface sont délivrés à l'ensemble concentrateur par le biais d'un port de sortie (27) de l'équipement de test, le port de sortie pouvant être connecté électriquement à l'ensemble concentrateur pour acheminer le signal de sortie à l'ensemble concentrateur,
et dans lequel le boîtier extérieur (6) comprend une monture (11) adaptée pour recevoir un dispositif à tester.

2. Équipement de test selon la revendication 1, dans lequel le module d'interface est configuré pour générer lesdits un ou plusieurs signaux de sortie pour qu'ils indiquent une quantité de lumière collectée par les collecteurs de lumière (14).

3. Équipement de test selon la revendication 2, dans lequel lesdits un ou plusieurs signaux de sortie indiquent une ou plusieurs caractéristiques parmi une intensité de la lumière collectée et un état activé/désactivé d'un élément producteur de lumière (2), déterminées à partir de la quantité de lumière collectée.

4. Équipement de test selon la revendication 1, 2 ou 3, dans lequel lesdits un ou plusieurs signaux de sortie indiquent une couleur de la lumière collectée.

5. Équipement de test selon l'une quelconque des revendications précédentes, dans lequel les convertisseurs (17) sont configurés pour générer les signaux électroniques sous la forme de signaux numériques.

6. Équipement de test selon l'une quelconque des revendications précédentes, dans lequel le module d'interface comporte :
un système de traitement (23) configuré pour réaliser une analyse des signaux électroniques et pour générer lesdits un ou plusieurs signaux de sortie sur la base du résultat de ladite analyse.

7. Équipement de test selon la revendication 6, dans lequel le module d'interface comprend :
une mémoire (24) configurée pour stocker de multiples algorithmes logiciels à utiliser dans l'analyse des signaux électroniques ;
dans lequel le système de traitement (23) est configuré pour recevoir une indication spécifiant une analyse à réaliser, sélectionner un des algorithmes logiciels stockés correspondant au test spécifié, et réaliser ladite analyse sur la base dudit algorithme sélectionné.

8. Équipement de test selon la revendication 7, dans lequel :
l'un au moins des multiples algorithmes logiciels correspond à une analyse de la lumière collectée par un sous-ensemble sélectionné des collecteurs de lumière (14).

9. Système de test (1) comprenant :
un équipement de test (4) selon l'une quelconque des revendications 1 à 8 ; et
l'ensemble concentrateur (5) extérieur au boîtier configuré pour recevoir et traiter lesdits un ou plusieurs signaux de sortie électroniques de l'équipement de test (4), dans lequel l'équipement de test est connecté électriquement à l'ensemble concentrateur pour acheminer les signaux de sortie à l'ensemble concentrateur pour l'analyse.

10. Procédé de test d'une pluralité d'éléments producteurs de lumière, comprenant, à l'intérieur d'un boîtier (6) d'un équipement de test (4) comprenant au moins un module d'interface et une monture (11) adapté pour recevoir un dispositif à tester :
la collecte de la lumière des éléments producteurs de lumière en utilisant une pluralité de collecteurs de lumière respectifs ;
la génération des signaux électroniques sur la base de la lumière collectée par des collecteurs respectifs parmi lesdits collecteurs de lumière ;
la génération d'un ou plusieurs signaux de sortie électroniques indiquant une caractéristique de la lumière collectée, sur la base des signaux électroniques ; et
l'acheminement desdits signaux de sortie électroniques à un ensemble concentrateur extérieur au boîtier qui est configuré pour recevoir des signaux de sortie électroniques d'une pluralité de modules d'interface séparés et pour analyser les signaux de sortie afin de déterminer des caractéristiques de la lumière collectée par chaque module d'interface, dans lequel les signaux de sortie électroniques du module d'interface sont délivrés à l'ensemble concentrateur par le biais d'un port de sortie (27) de l'équipement de test, le port de sortie pouvant être connecté au concentrateur (5).

11. Procédé selon la revendication 10, dans lequel lesdits un ou plusieurs signaux de sortie peuvent indiquer une ou plusieurs caractéristiques parmi une intensité de la lumière collectée, un état activé/désactivé d'un élément producteur de lumière déterminé à partir de la quantité de lumière collectée, et la couleur de la lumière collectée.

12. Procédé selon la revendication 10 ou la revendication 11, dans lequel :
la génération desdits un ou plusieurs signaux de sortie comporte la réalisation d'une analyse des signaux électroniques ; et
lesdits un ou plusieurs signaux de sortie peuvent comporter le résultat de cette analyse ou y correspondre.

13. Procédé selon la revendication 12, comprenant, au niveau de l'équipement de test (4) :
la réception d'une indication d'une analyse à réaliser ;
la sélection d'un parmi une pluralité d'algorithmes logiciels stockés à utiliser dans l'analyse des signaux électroniques ;
la réalisation de ladite analyse sur la base de l'algorithme logiciel sélectionné.

14. Procédé selon la revendication 13, dans lequel :
l'un au moins de la pluralité d'algorithmes logiciels stockés correspond à une analyse de la lumière collectée par un sous-ensemble des collecteurs de lumière (14).
